# EUROPÄISCHE PATENTSCHRIFT

(11) **EP 3 278 959 B1**
(45) Veröffentlichungstag und Bekanntmachung des Hinweises auf die Patenterteilung: **13.02.2019**
(21) Anmeldenummer: 16182214.3
(22) Anmeldetag: 01.08.2016
(51) Int. Cl.: B29C 65/22, H05B 3/12, H05B 3/16

(54) **HEIZANORDNUNG**
HEATER ASSEMBLY
SYSTEME DE CHAUFFAGE

(43) Veröffentlichungstag der Anmeldung: 07.02.2018
(73) Patentinhaber: ROPEX Industrie-Elektronik GmbH, 74321 Bietigheim-Bissingen (DE)
(72) Erfinder: PETERS, Robert, 74321 Bietigheim-Bissingen (DE); HUPP, Alexander, 75056 Sulzfeld (DE); BAIER, Maximilian Paul, 70191 Stuttgart (DE)
(74) Vertreter: Patentanwälte Magenbauer & Kollegen Partnerschaft mbB

(56) Entgegenhaltungen:
- WO-A1-2009/012621
- CN-A- 1 234 415
- US-A- 3 362 815
- US-A- 4 967 058
- US-A1- 2002 122 739
- US-A1- 2015 305 091

## Beschreibung

Die Erfindung betrifft eine Heizanordnung für eine thermischen Fügeeinrichtung, mit einem Grundkörper, der von einem Fluidkanal durchsetzt ist und der an einer Außenoberfläche mit einer Heizvorrichtung versehen ist, die eine als Dickschichtkeramik ausgebildete keramische Trägerschicht sowie einen metallischen Heizleiter umfasst.

Aus der DE 197 37 471 C2 ist eine Heizanordnung für Geräte zum thermischen Bearbeiten von Folien mit einem einer Kühlvorrichtung zugeordneten Substrat aus Metall bekannt, wobei auf dem Substrat eine elektrisch isolierende Schicht aufgebracht ist, auf der mindestens eine Dickschichtleiterbahn als Heizleiter aufgebracht ist.

Die Aufgabe der Erfindung besteht darin, eine Heizanordnung bereitzustellen, die eine verbesserte Standzeit bei einem Einsatz für ein thermisches Fügeverfahren aufweist.

Diese Aufgabe wird für eine Heizanordnung der eingangsgenannten Art mit den Merkmalen des Anspruchs 1 gelöst. Hierbei ist vorgesehen, dass der Heizleiter aus einer Haftschutzlegierung hergestellt ist und/oder dass der Heizleiter mit einer Beschichtung aus einer Haftschutzlegierung beschichtet ist, wobei die Haftschutzlegierung einen Anteil von wenigstens 5 Gewichtsprozent wenigstens eines Elements aus der Gruppe der Metalle der Seltenen Erden umfasst.

Eine Verwendungsdauer oder Standzeit einer Heizanordnung der eingangs genannten Art, die insbesondere im Bereich der Verschweißung von Kunststofffolien eingesetzt wird, hängt im Wesentlichen von der Wirkung einer Anti-Haft-Beschichtung ab. Diese Anti-Haft-Beschichtung wird auf den metallischen Heizleiter aufgebracht, um ein Anhaften des zu verschweißenden Materials am Heizleiter während der Durchführung des Fügevorgangs zu vermeiden. Bekannte Anti-Haft-Beschichtungen für Heizleiter basieren üblicherweise auf Polymerverbindungen, insbesondere auf der Verwendung von Polytetrafluorethylenverbindungen (PTFE). Mit derartigen Anti-Haft-Beschichtungen lässt sich bei einer neuwertigen Heizanordnung zunächst zuverlässig eine Anhaftung des zu verschweißenden Materials am Heizleiter vermeiden. Allerdings erfährt die Anti-Haft-Beschichtung durch mechanische Belastung, insbesondere Abrieb, einen Verschleiß, so dass sich die Anti-Haft-Eigenschaften langfristig verschlechtern.

Demgegenüber kann bei einer Herstellung des Heizleiters aus einer Haftschutzlegierung und/oder einer Beschichtung des Heizleiters mit einer Haftschutzlegierung, die zumindest anteilig zumindest ein Element aus der Gruppe der Metalle der Seltenen Erden (Cer, Dysprosium, Erbium, Europium, Gadolinium, Holmium, Lanthan, Lutetium, Neodym, Praseodym, Promethium, Samarium, Scandium, Terbium, Thulium, Ytterbium, Yttrium) umfasst, eine temperaturstabile und abriebfeste Anti-Haft-Beschichtung geschaffen werden, mit der eine Standzeit der Heizanordnung erheblich verbessert werden kann.

Grundlegende chemische Zusammensetzungen für derartige Haftschutzlegierungen gehen aus der WO 2013/141877 A1 hervor, die hiermit ausdrücklich zum Gegenstand dieser Offenbarung gemacht wird. Die in der WO 2013/141877 A1 offenbarten Materialzusammensetzungen und Materialeigenschaften werden in vorteilhafter Weise für die Heizanordnung der eingangs genannten Art genutzt. Hierbei ergeben sich durch das Zusammenwirken der Haftschutzlegierung mit der keramischen Trägerschicht und/oder dem metallischen Heizleiter synergistische Effekte, insbesondere im Hinblick auf die Verbesserung einer Wärmeleitung zwischen dem metallischen Heizleiter und den zu verschweißenden Materialien sowie im Hinblick auf eine Abschottung des Heizleiters und/oder der keramischen Trägerschicht gegenüber thermisch löslichen, ggf. korrosiv wirkenden Bestandteilen des zu verschweißenden Materials. Zudem werden durch die Verwendung von Haftschutzlegierungen mit Anteilen von Metallen der Seltenen Erden auch die Abriebfestigkeit der Anti-Haft-Beschichtung und damit die Standzeit der Heizanordnung verbessert.

Vorzugsweise ist vorgesehen, dass wenigstens das eine verwendete Element der Metalle der Seltenen Erden insbesondere in Form eines Oxids, Nitrids oder Carbids verwendet wird. Dies gilt insbesondere dann, wenn die Haftschutzlegierung elektrisch isolierend ausgebildet sein soll. Sofern die Haftschutzlegierung elektrisch leitende Eigenschaften aufweisen soll, können zumindest die metallischen Elemente der Metalle der Seltenen Erden in Reinform oder als Legierungen mit weiteren Stoffen, insbesondere Metallen, verwendet werden.

Wahlweise kann vorgesehen sein, dass die keramische Trägerschicht beim Auftrag der Haftschutzlegierung als noch nicht ausgehärteter Grünköper vorliegt, so dass ein gemeinsamer Brennvorgang für die keramische Trägerschicht und die Haftschutzlegierung stattfindet oder dass die keramische Trägerschicht bereits vor dem Auftrag der Haftschutzlegierung ausgehärtet ist.

Vorteilhafte Weiterbildungen der Erfindung sind Gegenstand der Unteransprüche.

Zweckmäßig ist es, wenn der Heizleiter aus einer gestaltlosen Masse, insbesondere in einem Sprühverfahren oder einem Siebdruckverfahren oder einem Direktdruckverfahren, auf die Trägerschicht aufgebracht und stoffschlüssig, insbesondere durch thermische Einwirkung, mit der Trägerschicht verbunden ist. Für eine Herstellung des Heizleiters wird eine gestaltlose Masse verwendet, bei der es sich insbesondere um eine zunächst zähflüssige oder dünnflüssige Lösung metallischer Partikel sowie Partikel wenigstens eines Elements aus der Gruppe der Metalle der Seltenen Erden in einem geeigneten Binder, handelt. Hiermit kann eine frei wählbare, insbesondere komplexe, Geometrie für den Heizleiter in einfacher Weise hergestellt werden. Dies gilt insbesondere für die Verwendung eines Siebdruckverfahrens, bei dem die gestaltlose Masse durch freigestellte Sieböffnungen eines ansonsten geschlossenen Siebs hindurchgepresst wird und somit in einem einzigen Arbeitsgang auch komplexe Geometrien für den Heizleiter geschaffen werden können. Bei der Verwendung eines Direktdruckverfahrens ist vorgesehen, die gestaltlose Masse durch eine Austragdüse, die an einem wenigstens in einer, vorzugsweise in zwei, insbesondere in drei linearen Raumrichtungen bewegbaren Druckkopf angeordnet ist, in frei wählbarer Weise auf die keramische Trägerschicht aufzubringen. Bei einer Verwendung eines Sprühverfahrens ist vorzugsweise vorgesehen, dass die gestaltlose Masse lokal auf die keramische Trägerschicht aufgebracht wird, um einen oder mehrere geschlossene Leiterzüge für den elektrischen Heizleiter zu bilden. Bei allen vorstehend angeführten Vorgehensweisen ist vorgesehen, nach der Aufbringung auf die keramische Trägerschicht eine thermische Einwirkung zur Aushärtung und stoffschlüssigen Anbindung der gestaltlosen Masse an die keramische Trägerschicht vorzusehen. Diese thermische Einwirkung kann beispielsweise ein Brennvorgang in einem geeigneten Brennofen, insbesondere mit Temperaturen oberhalb von 700°C, sein. Dabei kann wahlweise vorgesehen sein, dass die keramische Trägerschicht als noch nicht ausgehärteter Grünköper vorliegt, so dass ein gemeinsamer Brennvorgang für die keramische Trägerschicht und den Heizleiter stattfindet oder dass die keramische Trägerschicht bereits vor dem Auftrag des Heizleiters ausgehärtet ist.

Bei einer alternativen Weiterbildung der Erfindung ist vorgesehen, dass der Heizleiter aus einem Bandmaterial hergestellt ist, das insbesondere stoffschlüssig mit der Trägerschicht verbunden ist. Dieses Bandmaterial kann wahlweise als Haftschutzlegierung mit einem Anteil von wenigstens 5 Gewichtsprozent wenigstens eines Elements aus der Gruppe der Metalle der Seltenen Erden ausgebildet sein oder aus einem der üblichen metallischen Werkstoffe zur Herstellung von Heizleitern, insbesondere einer Edelstahllegierung, hergestellt sein. Ferner kann vorgesehen sein,, dass das zumindest weitestgehend formstabile, eventuell biegeschlaffe, Bandmaterial für die Herstellung des Heizleiters auf die keramische Trägerschicht aufgelegt wird und in einem geeigneten Herstellungsschritt stoffschlüssig mit der Trägerschicht verbunden, um eine dauerhafte Verbindung zwischen Heizleiter und Trägerschicht zu gewährleisten.

Bei einer vorteilhaften Weiterbildung der Erfindung ist vorgesehen, dass zwischen der Trägerschicht und dem Heizleiter eine Zwischenschicht zur Verbesserung einer stoffschlüssigen Verbindung zwischen Trägerschicht und Heizleiter angeordnet ist. Die Zwischenschicht ist vorzugsweise elektrisch isolierend, insbesondere als Schicht aus einer keramischen Verbindung mit Anteilen wenigstens eines Oxids oder Carbids oder Nitrids oder Fluorids oder Borids oder Silikats eines Metalls der Seltenen Erden, ausgebildet. Der Einsatz einer Zwischenschicht ist insbesondere dann von Interesse, wenn auch der Heizleiter aus einer Haftschutzlegierung hergestellt ist, die als Bandmaterial oder als aushärtbare, zunächst gestaltlose Masse vorliegenden kann, da hierdurch eine stoffschlüssige Anbindung an die keramische Trägerschicht verbesswert werden kann.

Vorzugsweise ist vorgesehen, dass zwischen dem Heizleiter und einer auf den Heizleiter aufgebrachten Beschichtung aus einer Haftschutzlegierung eine Zwischenschicht zur Verbesserung einer stoffschlüssigen Verbindung zwischen Heizleiter und Haftschutzlegierung angeordnet ist, wobei die Zwischenschicht vorzugsweise elektrisch isolierend, insbesondere als Schicht aus einer keramischen Verbindung mit Anteilen wenigstens eines Oxids oder Carbids oder Nitrids oder Fluorids oder Borids oder Silikats eines Metalls der Seltenen Erden, ausgebildet ist. Eine derartige Zwischenschicht kann sowohl für einen Heizleiter ohne einen Anteil von Metallen der Seltenen Erden als auch für einen Heizleiter, der einen Anteil von mindestens 5 Gewichtsprozent wenigstens eines Elements aus der Gruppe der Metalle der Seltenen Erden umfasst, von Interesse sein. In beiden Fällen dient die Zwischenschicht dazu, eine besonders zuverlässige Anhaftung der auf den Heizleiter aufzubringenden Beschichtung aus einer Haftschutzlegierung und dem Heizleiter zu gewährleisten, um eine besonders vorteilhafte Standfestigkeit für die Heizanordnung zu erzielen.

In weiterer Ausgestaltung der Erfindung ist vorgesehen, dass die auf den Heizleiter aufgebrachte Beschichtung aus einer Haftschutzlegierung als elektrische Isolationsschicht ausgebildet ist. Somit nimmt die Beschichtung aus der Haftschutzlegierung eine Doppelfunktion ein, da sie neben der Vermeidung einer Anhaftung des Heizleiters an den zu verschweißenden Materialien auch eine elektrische Isolation des Heizleiters gegenüber der Umgebung gewährleistet.

Zweckmäßig ist es, wenn eine auf den Heizleiter aufgebrachte Beschichtung aus einer Haftschutzlegierung durch Sprühen oder Sputtern oder Drucken oder Tauchen hergestellt ist. Durch diese Verfahren kann eine kostengünstige und präzise Aufbringung der Beschichtung aus der Haftschutzlegierung auf den Heizleiter gewährleistet werden. Mit Hilfe des Verfahrens des Sputterns (Kathodenzerstäubung) können besonders dünne Schichten der Beschichtung aus der Haftschutzlegierung auf den Heizleiter aufgebracht werden. Mit Hilfe der anderen Verfahren, insbesondere dem Drucken oder Tauchen, können dickere Schichten einer Beschichtung aus einer Haftschutzlegierung auf den Heizleiter aufgebracht werden. Bei Verwendung eines Sprühverfahrens kann ein Schichtdickenbereich abgedeckt werden, der oberhalb des Sputterns aber unterhalb des Druckens oder Tauchens liegt.

In weiterer Ausgestaltung der Erfindung ist vorgesehen, dass der Heizleiter aus einer ersten Haftschutzlegierung hergestellt ist, die einen ersten Gewichtsanteil wenigstens eines Elements aus der Gruppen der Metalle der Seltenen Erden aufweist und dass der Heizleiter mit einer Beschichtung aus einer zweiten Haftschutzlegierung beschichtet ist, die einen zweiten Gewichtsanteil wenigstens eines Elements aus der Gruppe der Metalle der Seltenen Erden aufweist, wobei der erste Gewichtsanteil kleiner als der zweite Gewichtsanteil ist. Bei einer derartigen Ausgestaltung des Heizleiters und der darauf aufgebrachten Beschichtung aus einer Haftschutzlegierung lässt sich eine vorteilhafte Anbindung des Heizleiters an die Trägerschicht sowie eine vorteilhafte Verbindung zwischen Heizleiter und der darauf aufgebrachten Beschichtung aus der Haftschutzlegierung gewährleisten. Hierbei werden Konzentrationsgefälle zwischen Trägerschicht, Heizleiter und Beschichtung aus Haftschutzlegierung im Hinblick auf den jeweiligen Gewichtsanteil an Metallen der Seltenen Erden vermindert, so dass große Sprünge zwischen dem jeweiligen Gewichtsanteil für die enthaltenen Elemente aus der Gruppe der Metalle der Seltenen Erden vermieden werden und dadurch die stoffschlüssigen Verbindungen zwischen den jeweiligen Schichten stabil sind.

Vorzugsweise ist vorgesehen, dass eine Schichtdicke einer auf den Heizleiter aufgebrachten Beschichtung aus der Haftschutzlegierung weniger als 500 Mikrometer, bevorzugt weniger als 100 Mikrometer, besonders bevorzugt weniger als 40 Mikrometer, insbesondere weniger als 20 Mikrometer beträgt. Hiermit wird insbesondere eine vorteilhafte thermische Kopplung zwischen Heizleiter und den zu verschweißenden Materialien gewährleistet, da bereits mit sehr geringen Schichtdicken eine zuverlässige Haftschutzwirkung der Beschichtung aus der Haftschutzlegierung gewährleistet werden kann.

Vorteilhafte Ausführungsformen der Erfindung sind in der Zeichnung dargestellt. Hierbei zeigt:
- Figur 1: eine erste Ausführungsform einer Heizanordnung, bei der eine Beschichtung als Haftschutzlegierung ausgebildet ist,
- Figur 2: eine zweite Ausführungsform einer Heizanordnung, bei der der Heizleiter und eine darauf aufgebrachte Beschichtung jeweils aus einer Haftschutzlegierung ausgebildet sind,
- Figur 3: eine weitere Ausführungsform einer Heizanordnung, bei der der Heizleiter und die Beschichtung aus einer Haftschutzlegierung ausgebildet sind und zwischen Heizleiter und Trägerschicht eine Zwischenschicht ausgebildet ist,
- Figur 4: eine weitere Ausführungsform einer Heizanordnung, bei der eine Beschichtung eines Heizleiters aus einer Haftschutzlegierung hergestellt ist und der Heizleiter gegenüber der Trägerschicht auf einer Zwischenschicht aufgebracht ist,
- Figur 5: eine weitere Ausführungsform einer Heizanordnung, bei der eine Beschichtung auf dem Heizleiter als aus einer Haftschutzlegierung hergestellt ist und der Heizleiter auf einer Zwischenschicht gegenüber der keramischen Trägerschicht aufgebracht ist,
- Figur 6: eine weitere Ausführungsform einer Heizanordnung, bei der der Heizleiter und eine auf den Heizleiter aufgebrachte Beschichtung jeweils aus einer Haftschutzlegierung hergestellt sind und zwischen Heizleiter und darauf aufgebrachte Beschichtung sowie der keramischen Trägerschicht jeweils eine Zwischenschicht ausgebildet ist, und
- Figur 7: eine seitliche Darstellung einer Heizanordnung.

Bei der nachfolgenden Beschreibung der unterschiedlichen Ausführungsformen der Erfindung werden für funktionsgleiche Komponenten jeweils um den Betrag Zwanzig verschiedene Bezugszeichen verwendet.

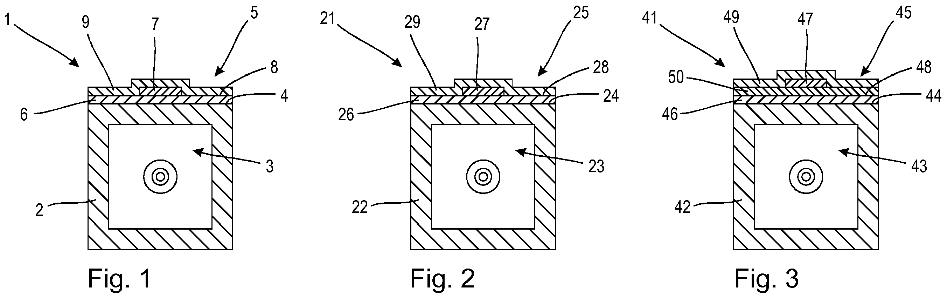

Eine in der Figur 1 dargestellte erste Ausführungsform einer Heizanordnung 1 ist zur Verwendung in einer nicht dargestellten Fügemaschine, insbesondere einer Schweißmaschine für Kunststofffolien, vorgesehen. Die Heizeinrichtung 1 umfasst einen profilierten Grundkörper 2, der rein exemplarisch als Rechteckrohr ausgebildet ist. Im Inneren weist der Grundkörper 2 einen Fluidkanal 3 auf, durch den bei Verwendung der Heizanordnung 1 in einer nicht dargestellten Fügemaschine ein Kühlfluid, vorzugsweise eine Kühlflüssigkeit, insbesondere Wasser, strömen kann. Beispielhaft ist vorgesehen, dass der Grundkörper 2 aus einem metallischen Werkstoff, insbesondere Aluminium oder Edelstahl, hergestellt ist und dass die keramische Trägerschicht 6 im Dickschicht-Verfahren auf die Außenoberfläche 4 des Grundkörpers 2 aufgebracht ist. Dabei dient die Trägerschicht 6 insbesondere zur elektrischen Isolierung und thermischen Kopplung des Heizleiters 7, der an einer Trägerfläche 8 der keramischen Trägerschicht 6 angeordnet ist, gegenüber dem Grundkörper 2.

Rein exemplarisch ist vorgesehen, dass der Heizleiter 7 einen rechteckigen Querschnitt aufweist und sich streifenförmig längs des Grundkörpers 2 erstreckt. Der Heizleiter 7 ist bei der Ausführungsform gemäß der Figur 1 aus einer gestaltlosen Masse mit metallischem Anteil, insbesondere Silber, hergestellt, die in geeigneter Weise stoffschlüssig mit der keramischen Trägerschicht 6 verbunden ist. Um ein Anhaften eines nicht dargestellten Werkstücks, insbesondere einer Kunststofffolie, an dem Heizleiter 7 zu vermeiden, der während eines Fügevorgangs in unmittelbarem Kontakt mit dem Werkstück gelangt, ist eine Beschichtung 9 vorgesehen, die zum einen den Heizleiter 7 als auch die übrige, nicht vom Heizleiter 7 bedeckte Trägerfläche 8 bedeckt und die als Haftschutzlegierung ausgebildet ist.

Vorzugsweise umfasst die als Haftschutzlegierung ausgebildete Beschichtung wenigstens einen Anteil von 5 Gewichtsprozent wenigstens eines Elements der Metalle der Seltenen Erden und ist insbesondere als Oxid, als Carbid, als Nitrit, als Fluorid als Borid oder als Silikat ausgebildet. Eine Aufbringung der Beschichtung 9, die ebenso wie der Heizleiter 7 und die keramische Trägerschicht 6 nicht maßstäblich dargestellt ist, kann beispielsweise durch Sprühen, Sputtern, Siebdrucken oder Tauchen erfolgen.

Exemplarisch ist vorgesehen, dass die keramische Trägerschicht eine Schichtdicke im Bereich kleiner 0,1 Millimeter aufweist, der Heizleiter eine Dicke von weniger als 0,07 Millimeter aufweist und die Beschichtung 9 eine Dicke von weniger als 0,04 Millimeter aufweist.

Die in der Figur 2 dargestellte zweite Ausführungsform einer Heizanordnung 21 unterscheidet sich von der Heizanordnung 1 gemäß der Figur 1 dadurch, dass der Heizleiter 27 aus einer Haftschutzlegierung hergestellt ist, die einen Anteil von wenigstens 5 Gewichtsprozent wenigstens eines Elements aus der Gruppe der Metalle der Seltenen Erden aufweist. Wahlweise kann der Heizleiter 27 aus einer gestaltlosen Masse auf die zugehörige keramische Trägerschicht 26 aufgebracht werden oder ist als Bandmaterial stoffschlüssig mit der keramischen Trägerschicht 26 verbunden.

Bei der in Figur 3 dargestellten dritten Ausführungsform einer Heizanordnung 41 sind übereinstimmend mit der in Figur 2 dargestellten zweiten Ausführungsform der Heizanordnung 21 sowohl der Heizleiter 47 als auch die Beschichtung 49 aus einer Haftschutzlegierung ausgebildet. Darüber hinaus ist zwischen der keramischen Trägerschicht 46 und dem Heizleiter 47 eine Zwischenschicht 50 wobei die Zwischenschicht vorzugsweise elektrisch isolierend, insbesondere als Schicht aus einer keramischen Verbindung mit Anteilen wenigstens eines Oxids oder Carbids oder Nitrids oder Fluorids oder Borids oder Silikats eines Metalls der Seltenen Erden, ausgebildet ist. Auch die Zwischenschicht 50 ist nicht maßstäblich dargestellt und dient einer vorteilhaften stoffschlüssigen Kopplung des Heizleiters 47 mit der keramischen Trägerschicht 46.

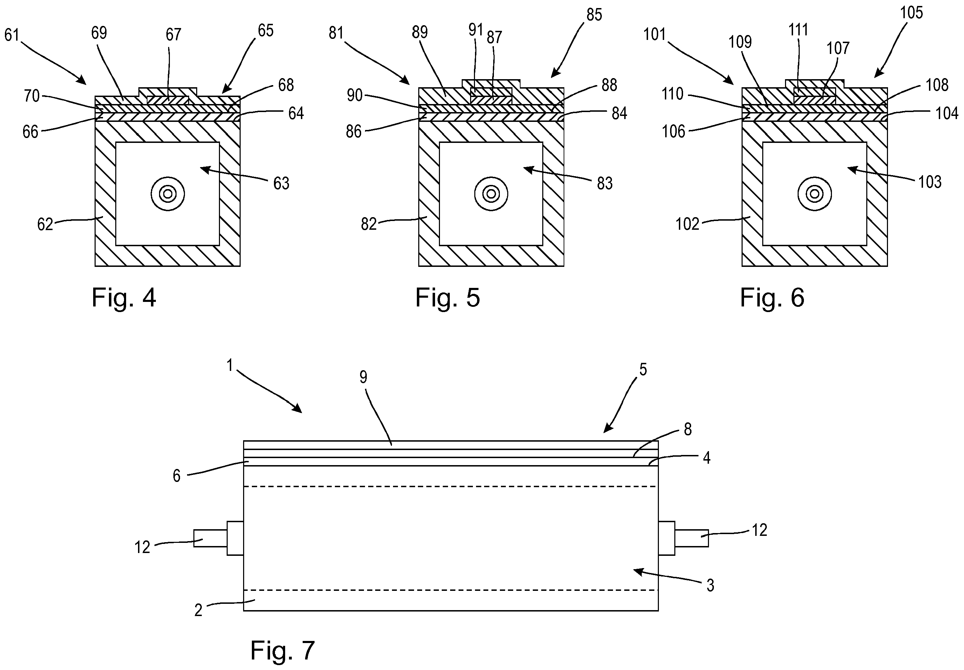

Die in der Figur 4 dargestellte vierte Ausführungsform einer Heizanordnung 61 unterscheidet sich von der Heizanordnung gemäß der Figur 3 lediglich dadurch, dass der Heizleiter 67 aus einem für derartige Heizleiter üblichen metallischen Material, beispielsweise einer Edelstahllegierung, hergestellt ist. Auch bei dieser Ausführungsform ist eine Zwischenschicht 70 zwischen dem Heizleiter 67 und der keramischen Trägerschicht 66 vorgesehen, wobei auch die als Haftschutzlegierung ausgebildete Beschichtung 69 bereichsweise auf der Zwischenschicht 70 stoffschlüssig angebunden ist.

Bei der in Figur 5 dargestellten fünften Ausführungsform einer Heizanordnung 81 handelt es sich um eine Variante der in Figur 1 dargestellten ersten Ausführungsform einer Heizanordnung 1, wobei zwischen dem aus einem metallischen Werkstoff, beispielsweise Edelstahl, hergestellten Heizleiter 87 und der keramischen Trägerschicht 86 eine Zwischenschicht 90 angeordnet ist. Diese Zwischenschicht 90 kann insbesondere als elektrisch isolierende Legierung, exemplarisch als Schicht aus einer keramischen Verbindung mit Anteilen wenigstens eines Oxids oder Carbids oder Nitrids oder Fluorids oder Borids oder Silikats eines Metalls der Seltenen Erden ausgebildet sein. Die Zwischenschicht 90 dient zur Verbesserung der stoffschlüssigen Verbindung zwischen dem aus einem konventionellen Werkstoff, beispielsweise Kupfer oder Silber mit Glasanteil, insbesondere einer gestaltlosen Masse, hergestellten Heizleiter 87 und der aus einer Haftschutzlegierung hergestellten Beschichtung 89. In gleicher Weise gilt dies auch für die Zwischenschicht 91, die zwischen dem Heizleiter 87 und der als Haftschutzlegierung ausgebildeten Beschichtung 89 vorgesehen ist.

Bei der in Figur 6 dargestellten sechsten Ausführungsform einer Heizanordnung 101 handelt es sich um eine Variante der in Figur 3 dargestellten dritten Ausführungsform einer Heizanordnung 41, bei der zusätzlich zur Zwischenschicht 110 zwischen dem Heizleiter 107 und der keramischen Trägerschicht 106 eine weitere Zwischenschicht 111 zwischen dem Heizleiter 107 und der als Haftschutzlegierung ausgebildeten Beschichtung 109 vorgesehen ist.

Aus der Darstellung der Figur 7 geht rein exemplarisch eine Seitenansicht der Heizanordnung 1 gemäß der Figur 1 hervor. An dem beispielhaft als Rechteckrohr ausgebildeten Grundkörper 2 sind jeweils endseitig Anschlussstutzen 12 angebracht, die eine Zufuhr und Abfuhr eines Kühlfluids in den bzw. aus dem nur gestrichelt eingezeichneten Fluidkanal 3 ermöglichen.

## Patentansprüche

1. Heizanordnung (1; 21; 41; 61; 81; 101) für eine thermische Fügeeinrichtung, mit einem Grundkörper (2; 22; 42; 62; 82; 102), der von einem Fluidkanal (3; 23; 43; 63; 83; 103) durchsetzt ist und der an einer Außenoberfläche (4; 24; 44; 64; 84; 104) mit einer Heizvorrichtung (5; 25; 45; 65; 85; 105) versehen ist, die eine als Dickschichtkeramik ausgebildete keramische Trägerschicht (6; 26; 46; 66; 86; 106) sowie einen metallischen Heizleiter (7; 27; 47; 67; 87; 107) umfasst, **dadurch gekennzeichnet, dass** der Heizleiter (7; 27; 47; 67; 87; 107) aus einer Haftschutzlegierung hergestellt ist und/oder dass der Heizleiter (7; 27; 47; 67; 87; 107) mit einer Beschichtung (9; 29; 49; 69; 89; 109) aus einer Haftschutzlegierung beschichtet ist, wobei die Haftschutzlegierung einen Anteil von wenigstens 5 Gewichtsprozent wenigstens eines Elements aus der Gruppe der Metalle der Seltenen Erden umfasst.

2. Heizanordnung (1; 21; 41; 61; 81; 101) nach Anspruch 1, **dadurch gekennzeichnet, dass** der Heizleiter (7; 27; 47; 67; 87; 107) aus einer gestaltlosen Masse, insbesondere in einem Sprühverfahren oder einem Siebdruckverfahren oder einem Direktdruckverfahren, auf die Trägerschicht (6; 26; 46; 66; 86; 106) aufgebracht und stoffschlüssig, insbesondere durch thermische Einwirkung, mit der Trägerschicht (6; 26; 46; 66; 86; 106) verbunden ist.

3. Heizanordnung (1; 21; 41; 61; 81; 101) nach Anspruch 1, **dadurch gekennzeichnet, dass** der Heizleiter (7; 27; 47; 67; 87; 107) aus einem Bandmaterial hergestellt ist.

4. Heizanordnung (1; 21; 41; 61; 81; 101) nach Anspruch 1, 2 oder 3, **dadurch gekennzeichnet, dass** zwischen der Trägerschicht (6; 26; 46; 66; 86; 106) und dem Heizleiter (7; 27; 47; 67; 87; 107) eine Zwischenschicht (50; 70; 110; 111) zur Verbesserung einer stoffschlüssigen Verbindung zwischen Trägerschicht (6; 26; 46; 66; 86; 106) und Heizleiter (7; 27; 47; 67; 87; 107) angeordnet ist, wobei die Zwischenschicht (50; 70; 110; 111) als vorzugsweise elektrisch isolierend, insbesondere als Schicht aus einer keramischen Verbindung mit Anteilen wenigstens eines Oxids oder Carbids oder Nitrids oder Fluorids oder Borids oder Silikats eines Metalls der Seltenen Erden, ausgebildet ist.

5. Heizanordnung (1; 21; 41; 61; 81; 101) nach Anspruch 1, 2, 3 oder 4, **dadurch gekennzeichnet, dass** zwischen dem Heizleiter (7; 27; 47; 67; 87; 107) und einer auf den Heizleiter (7; 27; 47; 67; 87; 107) aufgebrachten Beschichtung (9; 29; 49; 69; 89; 109) aus einer Haftschutzlegierung eine Zwischenschicht (50; 70; 110; 111) zur Verbesserung einer stoffschlüssigen Verbindung zwischen Heizleiter (7; 27; 47; 67; 87; 107) und Haftschutzlegierung angeordnet ist, wobei die Zwischenschicht (50; 70; 110; 111) vorzugsweise elektrisch isolierend, insbesondere als Schicht aus einer keramischen Verbindung mit Anteilen wenigstens eines Oxids oder Carbids oder Nitrids oder Fluorids oder Borids oder Silikats eines Metalls der Seltenen Erden, ausgebildet ist.

6. Heizanordnung (1; 21; 41; 61; 81; 101) nach Anspruch 1, **dadurch gekennzeichnet, dass** die auf den Heizleiter (7; 27; 47; 67; 87; 107) aufgebrachte Beschichtung (9; 29; 49; 69; 89; 109) aus einer Haftschutzlegierung als elektrische Isolationsschicht ausgebildet ist.

7. Heizanordnung (1; 21; 41; 61; 81; 101) nach Anspruch 1, **dadurch gekennzeichnet, dass** eine auf den Heizleiter (7; 27; 47; 67; 87; 107) aufgebrachte Beschichtung (9; 29; 49; 69; 89; 109) aus einer Haftschutzlegierung durch Sprühen oder Sputtern oder Drucken oder Tauchen hergestellt ist.

8. Heizanordnung (1; 21; 41; 61; 81; 101) nach Anspruch 1, **dadurch gekennzeichnet, dass** der Heizleiter (7; 27; 47; 67; 87; 107) aus einer ersten Haftschutzlegierung hergestellt ist, die einen ersten Gewichtsanteil wenigstens eines Elements aus der Gruppe der Metalle der Seltenen Erden aufweist und dass der Heizleiter (7; 27; 47; 67; 87; 107) mit einer Beschichtung (9; 29; 49; 69; 89; 109) aus einer zweiten Haftschutzlegierung beschichtet ist, die einen zweiten Gewichtsanteil wenigstens eines Elements aus der Gruppe der Metalle der Seltenen Erden aufweist, wobei der erste Gewichtsanteil kleiner als der zweite Gewichtsanteil ist.

9. Heizanordnung (1; 21; 41; 61; 81; 101) nach Anspruch 1, **dadurch gekennzeichnet, dass** eine Schichtdicke einer auf den Heizleiter (7; 27; 47; 67; 87; 107) aufgebrachten Beschichtung (9; 29; 49; 69; 89; 109) aus einer Haftschutzlegierung weniger als 500 Mikrometer, bevorzugt weniger als 100 Mikrometer, besonders bevorzugt weniger als 40 Mikrometer, insbesondere weniger als 20 Mikrometer, beträgt.

## Claims

1. Heating assembly (1; 21; 41; 61; 81; 101) for a thermal joining device, the assembly (1; 21; 41; 61; 81; 101) comprising a base body (2; 22; 42; 62; 82; 102), through which a fluid passage (3; 23; 43; 63; 83; 103) passes and which is provided on an external surface (4; 24; 44; 64; 84; 104) with a heating device (5; 25; 45; 65; 85; 105) comprising a ceramic substrate (6; 26; 46; 66; 86; 106) designed as a thick-film ceramic material and a metallic heating conductor (7; 27; 47; 67; 87; 107), **characterised in that** the heating conductor (7; 27; 47; 67; 87; 107) is produced from an anti-adhesion alloy, and/or that the heating conductor (7; 27; 47; 67; 87; 107) is coated with an anti-adhesion alloy coating (9; 29; 49; 69; 89; 109), the anti-adhesion alloy containing a proportion of at least 5 percent by weight of at least one element from the group of the metals of the rare earths.

2. Heating assembly (1; 21; 41; 61; 81; 101) according to claim 1, **characterised in that** the heating conductor (7; 27; 47; 67; 87; 107) is applied to the ceramic substrate (6; 26; 46; 66; 86; 106) as an amorphous mass, in particular in a spraying or screen printing process or in a direct printing process, and joined to the substrate (6; 26; 46; 66; 86; 106) by adhesive force, in particular involving thermal effects.

3. Heating assembly (1; 21; 41; 61; 81; 101) according to claim 1, **characterised in that** the heating conductor (7; 27; 47; 67; 87; 107) is produced from a strip material.

4. Heating assembly (1; 21; 41; 61; 81; 101) according to claim 1, 2 or 3, **characterised in that** an intermediate layer (50; 70; 110; 111) is placed between the substrate (6; 26; 46; 66; 86; 106) and the heating conductor (7; 27; 47; 67; 87; 107) for the improvement of an adhesive joint between the substrate (6; 26; 46; 66; 86; 106) and the heating conductor (7; 27; 47; 67; 87; 107), wherein the intermediate layer (50; 70; 110; 111) is preferably electrically insulating, being in particular a layer of a ceramic compound with proportions of at least one oxide or carbide or nitride or fluoride or boride or silicate of a metal of the rare earths.

5. Heating assembly (1; 21; 41; 61; 81; 101) according to claim 1, 2, 3 or 4, **characterised in that** an intermediate layer (50; 70; 110; 111) is placed between the heating conductor (7; 27; 47; 67; 87; 107) and an anti-adhesion alloy coating (9; 29; 49; 69; 89; 109) for the improvement of an adhesive joint between the heating conductor (7; 27; 47; 67; 87; 107) and the anti-adhesion alloy, wherein the intermediate layer (50; 70; 110; 111) is preferably electrically insulating, being in particular a layer of a ceramic compound with proportions of at least one oxide or carbide or nitride or fluoride or boride or silicate of a metal of the rare earths.

6. Heating assembly (1; 21; 41; 61; 81; 101) according to claim 1, **characterised in that** the coating (9; 29; 49; 69; 89; 109) applied to the heating conductor (7; 27; 47; 67; 87; 107) is formed as an electrically insulating layer from an anti-adhesion alloy.

7. Heating assembly (1; 21; 41; 61; 81; 101) according to claim 1, **characterised in that** the anti-adhesion alloy coating (9; 29; 49; 69; 89; 109) applied to the heating conductor (7; 27; 47; 67; 87; 107) is produced by spraying or sputtering or printing or dipping.

8. Heating assembly (1; 21; 41; 61; 81; 101) according to claim 1, **characterised in that** the heating conductor (7; 27; 47; 67; 87; 107) is produced from a first anti-adhesion alloy having a first part by weight of at least one element from the group of the metals of the rare earths, and **in that** the heating conductor (7; 27; 47; 67; 87; 107) is coated with a coating (9; 29; 49; 69; 89; 109) of a second anti-adhesion alloy having a second part by weight of at least one element from the group of the metals of the rare earths, the first part by weight being less than the second part by weight.

9. Heating assembly (1; 21; 41; 61; 81; 101) according to claim 1, **characterised in that** a layer thickness of an anti-adhesion alloy coating (9; 29; 49; 69; 89; 109) applied to the heating conductor (7; 27; 47; 67; 87; 107) is less than 500 micrometres, preferably less than 100 micrometres, particularly preferably less than 40 micrometres and in particular less than 20 micrometres.

## Revendications

1. Ensemble de chauffage (1 ; 21 ; 41 ; 61 ; 81 ; 101) pour un système d'assemblage thermique, avec un corps de base (2 ; 22 ; 42 ; 62 ; 82 ; 102), qui est traversé par un canal de fluide (3 ; 23 ; 43 ; 63 ; 83 ; 103) et qui est pourvu au niveau d'une surface extérieure (4 ; 24 ; 44 ; 64 ; 84 ; 104) d'un dispositif de chauffage (5 ; 25 ; 45 ; 65 ; 85 ; 105), qui comprend une couche de support (6 ; 26 ; 46 ; 66 ; 86 ; 106) céramique réalisée sous la forme d'une céramique à couche épaisse ainsi qu'un conducteur chauffant (7 ; 27 ; 47 ; 67 ; 87 ; 107) métallique, **caractérisé en ce que** le conducteur chauffant (7 ; 27 ; 47 ; 67 ; 87 ; 107) est fabriqué à partir d'un alliage de protection d'adhérence, et/ou que le conducteur chauffant (7 ; 27 ; 47 ; 67 ; 87 ; 107) est revêtu d'un revêtement (9 ; 29 ; 49 ; 69 ; 89 ; 109) composé d'un alliage de protection d'adhérence, dans lequel l'alliage de protection d'adhérence comprend une proportion d'au moins 5 pour cent en poids d'au moins un élément issu du groupe des métaux des terres rares.

2. Ensemble de chauffage (1 ; 21 ; 41 ; 61 ; 81 ; 101) selon la revendication 1, **caractérisé en ce que** le conducteur chauffant (7 ; 27 ; 47 ; 67 ; 87 ; 107) composé d'une masse sans forme est appliqué, en particulier lors d'un procédé d'aspersion ou d'un procédé de sérigraphie ou d'un procédé d'impression direct, sur la couche de support (6 ; 26 ; 46 ; 66 ; 86 ; 106) et est relié par liaison de matière, en particulier par une action thermique, à la couche de support (6 ; 26 ; 46 ; 66 ; 86 ; 106).

3. Ensemble de chauffage (1 ; 21 ; 41 ; 61 ; 81 ; 101) selon la revendication 1, **caractérisé en ce que** le conducteur chauffant (7 ; 27 ; 47 ; 67 ; 87 ; 107) est fabriqué à partir d'un matériau en bande.

4. Ensemble de chauffage (1 ; 21 ; 41 ; 61 ; 81 ; 101) selon la revendication 1, 2 ou 3, **caractérisé en ce qu'**une couche intermédiaire (50 ; 70 ; 110; 111) servant à améliorer une liaison par liaison de matière entre la couche de support (6 ; 26 ; 46 ; 66 ; 86 ; 106) et le conducteur chauffant (7 ; 27 ; 47 ; 67 ; 87 ; 107) est disposée entre la couche de support (6 ; 26 ; 46 ; 66 ; 86 ; 106) et le conducteur chauffant (7 ; 27 ; 47 ; 67 ; 87 ; 107), dans lequel la couche intermédiaire (50 ; 70 ; 110 ; 111) est réalisée de préférence de manière électriquement isolante, en particulier sous la forme d'une couche composée d'un composé céramique avec des proportions d'au moins un oxyde ou d'un carbure ou d'un nitrure ou d'un fluorure ou d'un borure ou d'un silicate d'un métal des terres rares.

5. Ensemble de chauffage (1 ; 21 ; 41 ; 61 ; 81 ; 101) selon la revendication 1, 2, 3 ou 4, **caractérisé en ce qu'**une couche intermédiaire (50 ; 70 ; 110 ; 111) servant à améliorer une liaison par liaison de matière entre le conducteur chauffant (7 ; 27 ; 47 ; 67 ; 87 ; 107) et l'alliage de protection d'adhérence est disposée entre le conducteur chauffant (7 ; 27 ; 47 ; 67 ; 87 ; 107) et un revêtement (9 ; 29 ; 49 ; 69 ; 89 ; 109), appliqué sur le conducteur chauffant (7 ; 27 ; 47 ; 67 ; 87 ; 107), composé d'un alliage de protection d'adhérence, dans lequel la couche intermédiaire (50 ; 70 ; 110 ; 111) est réalisée de préférence de manière électriquement isolante, en particulier sous la forme d'une couche composée d'un composé céramique avec des proportions d'au moins un oxyde ou d'un carbure ou d'un nitrure ou d'un fluorure ou d'un borure ou d'un silicate d'un métal des terres rares.

6. Ensemble de chauffage (1 ; 21 ; 41 ; 61 ; 81 ; 101) selon la revendication 1, **caractérisé en ce que** le revêtement (9 ; 29 ; 49 ; 69 ; 89 ; 109) appliqué sur le conducteur chauffant (7 ; 27 ; 47 ; 67 ; 87 ; 107) composé d'un alliage de protection d'adhérence est réalisé sous la forme d'une couche d'isolation électrique.

7. Ensemble de chauffage (1 ; 21 ; 41 ; 61 ; 81 ; 101) selon la revendication 1, **caractérisé en ce qu'**un revêtement (9 ; 29 ; 49 ; 69 ; 89 ; 109), appliqué sur le conducteur chauffant (7 ; 27 ; 47 ; 67 ; 87 ; 107), composé d'un alliage de protection d'assurance est fabriqué par aspersion ou pulvérisation ou impression ou immersion.

8. Ensemble de chauffage (1 ; 21 ; 41 ; 61 ; 81 ; 101) selon la revendication 1, **caractérisé en ce que** le conducteur chauffant (7 ; 27 ; 47 ; 67 ; 87 ; 107) est fabriqué à partir d'un premier alliage de protection d'adhérence, qui présente une première proportion en poids d'au moins un élément issu du groupe des métaux des terres rares, et que le conducteur chauffant (7 ; 27 ; 47 ; 67 ; 87 ; 107) est revêtu d'un revêtement (9 ; 29 ; 49 ; 69 ; 89 ; 109) composé d'un deuxième alliage de protection d'adhérence, qui présente une deuxième proportion en poids d'au moins un élément issu du groupe des métaux des terres rares, dans lequel la première proportion en poids est inférieure à la deuxième proportion en poids.

9. Ensemble de chauffage (1 ; 21 ; 41 ; 61 ; 81 ; 101) selon la revendication 1, **caractérisé en ce qu'**une épaisseur de couche d'un revêtement (9 ; 29 ; 49 ; 69 ; 89 ; 109), appliqué sur le conducteur chauffant (7 ; 27 ; 47 ; 67 ; 87 ; 107), composé d'un alliage de protection d'adhérence présente une valeur inférieure à 500 micromètres, de manière préférée inférieure à 100 micromètres, de manière particulièrement préférée inférieure à 40 micromètres, en particulier inférieure à 20 micromètres.
